# EUROPÄISCHE PATENTSCHRIFT

(11) **EP 3 112 497 B1**
(45) Veröffentlichungstag und Bekanntmachung des Hinweises auf die Patenterteilung: **14.04.2021**
(21) Anmeldenummer: 16176945.0
(22) Anmeldetag: 29.06.2016
(51) Int. Cl.: C23C 16/26, C22C 23/00

(54) **GRAPHENBESSCHICHTUNG AUF EINEM MAGNESIUMLEGIERUNGSSUBSTRAT**
GRAPHENE COATING ON A MAGNESIUM ALLOY SUBSTRATE
REVÊTEMENT DE GRAPHÈNE SUR UN SUBSTRAT EN ALLIAGE DE MAGNÉSIUM

(30) Priorität: 30.06.2015 DE 102015008438
(43) Veröffentlichungstag der Anmeldung: 04.01.2017
(73) Patentinhaber: Airbus Defence and Space GmbH, 82024 Taufkirchen (DE); Chemetall GmbH, 60487 Frankfurt am Main (DE)
(72) Erfinder: Lenczowski, Blanka, 85579 Neubiberg (DE); Karch, Christian, 85579 Neubiberg (DE); Ostrovsky, Ilya, 63452 Hanau (IL)

(56) Entgegenhaltungen:
- KR-B1- 101 316 504
- KHORKOUNOV B ET AL: "Improving the performance of hydrogen storage electrodes based on mechanically alloyed Mg61Ni30Y9", JOURNAL OF ALLOYS AND COMPOUNDS, ELSEVIER SEQUOIA, LAUSANNE, CH, vol. 458, no. 1-2, 30 June 2008 (2008-06-30), pages 479-486, XP022647557, ISSN: 0925-8388, DOI: 10.1016/J.JALLCOM.2007.04.007 [retrieved on 2008-05-07]
- SINEBRYUKHOV S L ET AL: "Protective oxide coatings on Mg-Mn-Ce, Mg-Zn-Zr, Mg-Al-Zn-Mn, Mg-Zn-Zr-Y, and Mg-Zr-Nd magnesium-based alloys", PROTECTION OF METALS AND PHYSICAL CHEMISTRY OF SURFACES, SP MAIK NAUKA/INTERPERIODICA, DORDRECHT, vol. 48, no. 6, 16 November 2012 (2012-11-16), pages 678-687, XP035151057, ISSN: 2070-206X, DOI: 10.1134/S2070205112060147

## Beschreibung

Die vorliegende Erfindung betrifft ein Kompositwerkstoff umfassend eine Magnesiumlegierung und eine Schicht bestehend aus nanoskaligen Graphen-Plättchen auf mindestens einem Teil der Oberfläche der Magnesiumlegierung, ein Verfahren zur Herstellung eines solchen Kompositwerkstoffes sowie die Verwendung eines solchen Kompositwerkstoffes.

### Hintergrund der Erfindung

Magnesiumlegierungen sind leichter als Aluminiumlegierungen und sind daher von großem Interesse für die Luftfahrtindustrie. Viele Magnesiumlegierungen weisen jedoch eine geringe Schmelztemperatur (etwa 647 °C) und Siedetemperatur (etwa 1087 °C) sowie eine hohe Reaktivität, insbesondere geringe Korrosionsbeständigkeit, auf, so dass Magnesiumlegierungen bisher kaum eingesetzt werden.

Die thermischen und mechanischen Eigenschaften von Magnesium können jedoch durch Zusatz von Legierungskomponenten, wie z.B. Metalle der seltenen Erden, verbessert werden. So wurden bereits Magnesiumlegierungen entwickelt, wie z.B. WE43, WE54, ZE41, ZE10 oder Elektron 21 von Magnesium Elektron, UK, die gute mechanische Eigenschaften bei erhöhten Temperaturen aufweisen.

Durch den Zusatz von Metallen der seltenen Erden weisen diese Magnesiumlegierungen ausserdem eine verbesserte Entzündungs- und Flammbeständigkeit auf. Eine weitere Möglichkeit besteht darin, konventionelle Magnesiumlegierungen wie beispielsweise AZ31B oder AZ91 E mit einem entsprechenden Film, der einen aktiven Flammschutz beinhaltet, zu beschichten. Entsprechende Magnesiumlegierungen werden bisher hauptsächlich in der Automobilindustrie eingesetzt.

Die bekannten Magnesiumlegierungen weisen für die Luftfahrt- oder Automobilindustrie jedoch nur unzureichende mechanische und chemische Eigenschaften auf, so dass die bekannten Magnesiumlegierungen für solche Anwendungen nur begrezt geeignet sind.

Es wäre somit wünschenswert einen Werkstoff bereitzustellen, der, im Vergleich zu herkömmlichen Magnesiumlegierungen, verbesserte mechanische Eigenschaften, insbesondere eine verbesserte Festigkeit, und chemische Eigenschaften, insbesondere eine verbesserte Flamm- und Korrosionsbeständigkeit, aufweist. Des Weiteren ist es wünschenswert einen Kompositwerkstoff bereitzustellen, der ein geringers Brandrisiko und eine verbesserte Abriebs- und Degradierungsbeständigkeit, im Vergleich zu herkömmlichen Magnesiumlegierungen, aufweist. Ausserdem ist es wünschenswert einen Kompositwerkstoff bereitzustellen, der als Material in der Luftfahrtindustrie, z.B. Passagiertransportfahrzeugen und unbemannten Luftfahrzeugen, oder der Automobilindustrie eingesetzt werden kann. Ferner ist es wünschenswert einen Kompositwerkstoff bereitzustellen, der im Vergleich zu herkömmlichen Aluminiumlegierungen, ein geringeres Gewicht aufweist und so zu einem geringen Gesamtgewicht der Fahrzeuge generell beiträgt. Relevanter Stand der Technik ist in dem Dokument KR 101 316 504 B1 offenbart.

Aufgabe der vorliegenden Erfindung ist daher, einen Kompositwerkstoff zur Verfügung zu stellen, der im Vergleich zu herkömmlichen Magnesiumlegierungen, verbesserte mechanische Eigenschaften, insbesondere eine verbesserte Festigkeit, aufweist. Eine weitere Aufgabe der vorliegenden Erfindung ist, dass der Kompositwerkstoff, im Vergleich zu herkömmlichen Magnesiumlegierungen, verbesserte chemische Eigenschaften, insbesondere eine verbesserte Flamm- und Korrosionsbeständigkeit, aufweist. Eine weitere Aufgabe der vorliegenden Erfindung ist, dass der Kompositwerkstoff ein geringers Brandrisiko und eine verbesserte Abriebs- und Degardierungsbeständigkeit, im Vergleich zu herkömmlichen Magnesiumlegierungen, aufweist. Ferner ist eine Aufgabe der vorliegenden Erfindung, dass der Kompositwerkstoff als Material in der Luftfahrtindustrie, wie z.B. Passagiertransportfahrzeugen und unbemannten Luftfahrzeugen, eingesetzt werden kann. Ferner ist eine Aufgabe der vorliegenden Erfindung, dass der Kompositwerkstoff ein geringes Gewicht, insbesondere im Vergleich zu herkömmlichen Aluminiumlegierungen, aufweist und somit zu einem geringeren Gewicht des Luftfahrzeugs beiträgt. Eine weitere Aufgabe der vorliegenden Erfindung ist es, ein Verfahren zur Herstellung eines solchen Kompositwerkstoffes zur Verfügung zu stellen. Insbesondere soll dieses Verfahren einen niedrigen Fertigungsaufwand aufweisen.

Diese Aufgaben werden durch die in den Ansprüchen definierten Gegenstände gelöst. Vorteilhafte Ausführungsformen sind Gegenstand von Unteransprüchen.

### Zusammenfassung der Erfindung

Ein erster Gegenstand der vorliegenden Erfindung ist dementsprechend ein Kompositwerkstoff umfassend
a) eine Magnesiumlegierung, und
b) eine Schicht bestehend aus nanoskaligen Graphen-Plättchen auf mindestens einem Teil der Oberfläche der Magnesiumlegierung,
wobei die Magnesiumlegierung als weitere Legierungskomponente mindestens eine Komponente ausgewählt aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm), Europium (Er) oder Mischungen hiervon umfasst, und wobei die nanoskaligen Graphen-Plättchen eine Dicke von 1 bis 100 nm aufweisen.

Der erfindungsgemäße Kompositwerkstoff ist als Werkstoff für Luftfahrzeuge, z.B. Passagiertransportfahrzeuge und unbemannte Luftfahrzeuge, geeignet. Ein weiterer Vorteil ist, dass der Kompositwerkstoff verbesserte mechanische Eigenschaften aufweist, insbesondere eine verbesserte Festigkeit. Ein weiterer Vorteil ist, dass der Kompositwerkstoff verbesserte chemische Eigenschaften aufweist, insbesondere eine verbesserte Flamm- und Korrosionsbeständigkeit. Ein weiterer Vorteil ist, dass der Kompositwerkstoff ein geringers Brandrisiko und eine verbesserte Abriebs- und Degardierungsbeständigkeit, im Vergleich zu herkömmlichen Magnesiumlegierungen, aufweist. Ein weiterer Vorteil ist, dass der Kompositwerkstoff mit einem niedrigen Fertigungsaufwand hergestellt werden kann uns ein geringes Gewicht aufweist.

Erfindungsgemäß umfasst die Magnesiumlegierung als weitere Legierungskomponente mindestens eine Komponente ausgewählt aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm), Europium (Eu) oder Mischungen hiervon.

Beispielsweise umfasst die Magnesiumlegierung Magnesium in einer Menge von 80% bis 98 Gew.-%, bezogen auf das Gesamtgewicht der Magnesiumlegierung. Beispielsweise liegt die Schicht bestehend aus nanoskaligen Graphen-Plättchen im Wesentlichen auf der gesamten Oberfläche der Magnesiumlegierung vor. Beispielsweise weist die Schicht bestehend aus nanoskaligen Graphen-Plättchen eine Schichtdicke von 10 bis 1 000 nm auf.

Beispielsweise besteht die Schicht bestehend aus nanoskaligen Graphen-Plättchen aus mehreren Schichten.

Erfindungsgemäß weisen die nanoskaligen Graphen-Plättchen eine Dicke von 1 bis 100 nm auf. Beispielsweise weisen die nanoskaligen Graphen-Plättchen eine Länge, Breite oder Durchmesser von ≤100 µm auf. Beispielsweise werden die nanoskaligen Graphen-Plättchen durch mechanische oder chemische Verfahren erhalten.

Beispielsweise weist die Schicht bestehend aus nanoskaligen Graphen-Plättchen
a) eine thermische Leitfähigkeit von ≥ 1 Wm⁻¹K⁻¹, und/oder
b) eine Schmelztemperatur von ≥ 3725 °C, und/oder
c) eine Zugfestigkeit von 1 bis 10 GPa, und/oder
d) eine elektrische Leitfähigkeit von ≤ 10⁷ Ω⁻¹ cm⁻¹, auf.

Beispielsweise wird der Kompositwerkstoff durch das hierin beschriebene Verfahren erhalten.

Die vorliegende Erfindung stellt ferner ein Verfahren zur Herstellung des Kompositwerkstoffes zur Verfügung, das Verfahren umfassend
a) Bereitstellen einer Magnesiumlegierung, wie hierin definiert,
b) Bereitstellen von nanoskaligen Graphen-Plättchen, wie hierin definiert,
c) Aufbringen der nanoskaligen Graphen-Plättchen aus Schritt b) auf mindestens einem Teil der Oberfläche der Magnesiumlegierung aus Schritt a) zur Herstellung eines Kompositwerkstoffes.

Beispielsweise erfolgt das Aufbringen der nanoskaligen Graphen-Plättchen auf mindestens einem Teil der Oberfläche der Magnesiumlegierung in Schritt c) durch chemische Gasphasenabscheidung (CVD), epitaktisches Wachstum oder Abscheidung aus einer organischen Matrix.

Beispielsweise wird die Magnesiumlegierung vor Schritt c) durch Aufbringen einer organischen oder anorganischen Beschichtung, die zu einer geringeren Oberflächenleitfähigkeit der Magnesiumlegierung führt, vorbehandelt.

Ebenso betrifft die vorliegende Erfindung die Verwendung des Kompositwerkstoffes in einem Passagiertransportfahrzeug, insbesondere in Luftfahrzeugen wie Passagierflugzeugen, Hubschrauber oder einem unbemannten Luftfahrzeug, beispielsweise in einer Flugzeugzelle, in einem Raumfahrzeug, Transportfahrzeug, insbesondere in Bahnen und Schiffen, im Automobilbau, Anlagenbau, Maschinenbau oder Werkzeugbau.

### Detaillierte Beschreibung der Erfindung

Die vorliegende Erfindung betrifft einen Kompositwerkstoff umfassend
a) eine Magnesiumlegierung, und
b) eine Schicht bestehend aus nanoskaligen Graphen-Plättchen auf mindestens einem Teil der Oberfläche der Magnesiumlegierung,
wobei die Magnesiumlegierung als weitere Legierungskomponente mindestens eine Komponente ausgewählt aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm), Europium (Er) oder Mischungen hiervon umfasst, und wobei die nanoskaligen Graphen-Plättchen eine Dicke von 1 bis 100 nm aufweisen.

Ein Erfordernis der vorliegenden Erfindung ist demnach, dass der Kompositwerkstoff eine Magnesiumlegierung umfasst. Die Verwendung von Magnesiumlegierungen ist vorteilhaft, da diese ein geringes Gewicht aufweisen, insbesondere im Vergleich zu Aluminiumlegierungen, und somit zu einem geringeren Gesamtgewicht des Luftfahrzeugs beitragen.

Die Magnesiumlegierung umfasst vorzugsweise mindestens ein Metall der seltenen Erden als weitere Legierungskomponente. Dies hat den Vorteil, dass die Magnesiumlegierung gute mechanische Eigenschaften bei erhöhten Temperaturen sowie eine verbesserte Entzündungs- und Flammbeständigkeit aufweisen.

Erfindungsgemäß umfasst die Magnesiumlegierung als weitere Legierungskomponente daher mindestens eine Komponente ausgewählt aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), adolinium (Gd), Scandium (Sc), Lanthan (La), Cer (Ce), Praseodym (Pr), Promethium (Pm), Samarium (Sm), Europium (Eu), oder Mischungen hiervon.

Beispielsweise umfasst die Magnesiumlegierung als weitere Legierungskomponente mindestens zwei Komponenten, beispielsweise zwei Komponenten, ausgewählt aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm) und Europium (Eu). Alternativ umfasst die Magnesiumlegierung als weitere Legierungskomponente mindestens drei Komponenten, beispielsweise drei Komponenten, ausgewählt aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm) und Europium (Eu).

In einer Ausführungsform umfasst die Magnesiumlegierung als weitere Legierungskomponente Yttrium (Y) und Zirkonium (Zr).

In einer weiteren Ausfühtrungsform umfasst die Magnesiumlegierung als weitere Legierungskomponente Yttrium (Y), Zirkonium (Zr), und mindestens eine Komponente, ein oder zwei oder drei Komponenten, ausgewählt aus der Gruppe umfassend Neodym (Nd), Terbium (Tb), Dysprosium (Dy), Holmium (Ho), Erbium (Er), Thulium (Tm), Ytterbium (Yb), Lutetium (Lu), Zink (Zn), Gadolinium (Gd), Scandium (Sc), Lanthan (La), Cer (Ce), Praseodym (Pr), Promethium (Pm), Samarium (Sm) Europium (Eu), Aluminium (AI), Calcium (Ca), Silicium (Si), Mangan (Mn), Lithium (Li) und Silber (Ag).

Alternativ umfasst die Magnesiumlegierung als weitere Legierungskomponente Yttrium (Y), Neodym (Nd) und Zirkonium (Zr).

In einer Ausfühtrungsform umfasst die Magnesiumlegierung als weitere Legierungskomponente Yttrium (Y), Neodym (Nd), Zirkonium (Zr), und mindestens eine Komponente, ein oder zwei oder drei Komponenten, ausgewählt aus der Gruppe umfassend Terbium (Tb), Dysprosium (Dy), Holmium (Ho), Erbium (Er), Thulium (Tm), Ytterbium (Yb), Lutetium (Lu), Zink (Zn), Gadolinium (Gd), Scandium (Sc), Lanthan (La), Cer (Ce), Praseodym (Pr), Promethium (Pm), Samarium (Sm) Europium (Eu), Aluminium (Al), Calcium (Ca), Silicium (Si), Mangan (Mn), Lithium (Li) und Silber (Ag).

In einer Ausführungsform der vorliegenden Erfindung umfasst die Magnesiumlegierung als weitere Legierungskomponente mindestens eine Komponente, beispielsweise zwei oder drei oder vier Komponenten, ausgewählt aus der Gruppe umfassend Yttrium (Y), Neodym (Nd), Terbium (Tb), Dysprosium (Dy), Holmium (Ho), Ytterbium (Yb), Lutetium (Lu), Zirkonium (Zr), Zink (Zn), Gadolinium (Gd), Scandium (Sc), Lanthan (La), Cer (Ce), Aluminium (AI), Calcium (Ca), Silicium (Si), Mangan (Mn), Lithium (Li) und Silber (Ag).

Die Magnesiumlegierung weist insbesondere gute mechanische Eigenschaften bei erhöhten Temperaturen sowie eine verbesserte Entzündungs- und Flammbeständigkeit auf, wenn die mindestens eine weitere Legierungskomponente in einer bestimmten Menge enthalten ist.

Die Magnesiumlegierung umfasst Magnesium (Mg) daher vorzugsweise in einer Menge von 80 bis 98 Gew.-%, bezogen auf das Gesamtgewicht der Magnesiumlegierung.

Beispielsweise umfasst die Magnesiumlegierung Magnesium (Mg) in einer Menge von 89 bis 96 Gew.-%, bezogen auf das Gesamtgewicht der Magnesiumlegierung. In einer Ausführungsform umfasst die Magnesiumlegierung Magnesium (Mg) in einer Menge von 89 bis 94 Gew.-%, bezogen auf das Gesamtgewicht der Magnesiumlegierung.

Die Magnesiumlegierung umfasst Magnesium (Mg) und die mindestens eine weitere Legierungskomponente, die ausgewählt ist aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm), Europium (Eu) oder Mischungen hiervon, vorzugsweise in einer Menge von insgesamt mindestens 90 Gew.-%, bezogen auf das Gesamtgewicht der Magnesiumlegierung.

Beispielsweise umfasst die Magnesiumlegierung Magnesium (Mg) und die mindestens eine weitere Legierungskomponente, die ausgewählt ist aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm), Europium (Eu) oder Mischungen hiervon, vorzugsweise in einer Menge von insgesamt mindestens 91 Gew.-%, bevorzugt von insgesamt mindestens 92 Gew.-% und am meisten bevorzugt von insgesamt mindestens 93 Gew.-% bezogen auf das Gesamtgewicht der Magnesiumlegierung.

In einer Ausführungsform der vorliegenden Erfindung umfasst die Magnesiumlegierung Magnesium (Mg) und die mindestens eine weitere Legierungskomponente, die ausgewählt ist aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm), Europium (Eu) oder Mischungen hiervon, vorzugsweise in einer Menge von insgesamt mindestens 94 Gew.-%, bevorzugt von insgesamt mindestens 96 Gew.-%, weiter bevorzugt von insgesamt mindestens 98 Gew.-% und am meisten bevorzugt von insgesamt mindestens 99 Gew.-% bezogen auf das Gesamtgewicht der Magnesiumlegierung.

In einer Ausführungsform der vorliegenden Erfindung umfasst die Magnesiumlegierung Magnesium (Mg) und die mindestens eine weitere Legierungskomponente, die ausgewählt ist aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm), Europium (Eu) oder Mischungen hiervon, vorzugsweise insgesamt in einer Menge von 90 bis 100 Gew.-% oder insgesamt in einer Menge von 90 bis 99.99 Gew.-%, bezogen auf das Gesamtgewicht der Magnesiumlegierung.

Beispielsweise umfasst die Magnesiumlegierung Magnesium (Mg) und die mindestens eine weitere Legierungskomponente, die ausgewählt ist aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm), Europium (Eu) oder Mischungen hiervon, vorzugsweise insgesamt in einer Menge von 90 bis 99.95 Gew.-%, bevorzugt von 90 bis 99.5 Gew.-% und am meisten bevorzugt von 90 bis 99.45 Gew.-%, bezogen auf das Gesamtgewicht der Magnesiumlegierung.

In einer Ausführungsform der vorliegenden Erfindung umfasst die Magnesiumlegierung Magnesium (Mg) und die mindestens eine weitere Legierungskomponente, die ausgewählt ist aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm), Europium (Eu) oder Mischungen hiervon, vorzugsweise insgesamt in einer Menge von 94 bis 99.95 Gew.-%, bevorzugt von 94 bis 99.5 Gew.-% und am meisten bevorzugt von 94 bis 99.45 Gew.-%, bezogen auf das Gesamtgewicht der Magnesiumlegierung.

Alternativ umfasst die Magnesiumlegierung Magnesium (Mg) und die mindestens eine weitere Legierungskomponente, die ausgewählt ist aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm), Europium (Eu) oder Mischungen hiervon, vorzugsweise insgesamt in einer Menge von 98 bis 99.95 Gew.-%, bevorzugt von 98 bis 99.5 Gew.-% und am meisten bevorzugt von 98 bis 99.45 Gew.-%, bezogen auf das Gesamtgewicht der Magnesiumlegierung.

Die Magnesiumlegierung umfasst die mindestens eine weitere Legierungskomponente, die ausgewählt ist aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm), Europium (Eu) oder Mischungen hiervon, vorzugsweise in einer Gesamtmenge von 2 bis 20 Gew.-%, bezogen auf das Gesamtgewicht der Magnesiumlegierung. Beispielsweise umfasst die Magnesiumlegierung die mindestens eine weitere Legierungskomponente, die ausgewählt ist aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm), Europium (Eu) oder Mischungen hiervon, in einer Gesamtmenge von 4 bis 11 Gew.-%, bezogen auf das Gesamtgewicht der Magnesiumlegierung.

In einer Ausführungsform umfasst die Magnesiumlegierung die mindestens eine weitere Legierungskomponente, die ausgewählt ist aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm), Europium (Eu) oder Mischungen hiervon, in einer Gesamtmenge von 6 bis 11 Gew.-%, bezogen auf das Gesamtgewicht der Magnesiumlegierung.

In einer Ausführungsform der vorliegenden Erfindung umfasst die Magnesiumlegierung die mindestens eine weitere Legierungskomponente, die ausgewählt ist aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm), Europium (Eu) oder Mischungen hiervon, in einer Menge von 0.05 bis 6 Gew.-% pro Element, bezogen auf das Gesamtgewicht der Magnesiumlegierung.

Beispielsweise umfasst die Magnesiumlegierung die mindestens eine weitere Legierungskomponente, die ausgewählt ist aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm), Europium (Eu) oder Mischungen hiervon, in einer Gesamtmenge von 0.1 bis 5.5 Gew.-% pro Element, bezogen auf das Gesamtgewicht der Magnesiumlegierung.

Um eine Magnesiumlegierung mit guten mechanischen Eigenschaften bei erhöhten Temperaturen sowie einer verbesserten Entzündungs- und Flammbeständigkeit zu erhalten, ist es vorteilhaft, dass die Magnesiumlegierung Yttrium (Y) als mindestens eine weitere Legierungskomponente umfasst.

Umfasst die Magnesiumlegierung Yttrium (Y) als mindestens eine weitere Legierungskomponente, umfasst die Magnesiumlegierung Yttrium (Y) vorzugsweise in einer Menge von 0.05 bis 6 Gew.-%, bezogen auf das Gesamtgewicht der Magnesiumlegierung. Beispielsweise umfasst die Magnesiumlegierung Yttrium (Y) in einer Menge von 0.1 bis 5.5 Gew.-%, bezogen auf das Gesamtgewicht der Magnesiumlegierung. In einer Ausführungsform umfasst die Magnesiumlegierung Yttrium (Y) in einer Menge von 2 bis 5.5 Gew.-%, bezogen auf das Gesamtgewicht der Magnesiumlegierung. In einer bevorzugten Ausführungsform umfasst die Magnesiumlegierung Yttrium (Y) in einer Menge von 4.5 bis 5.5 Gew.-%, bezogen auf das Gesamtgewicht der Magnesiumlegierung. Alternativ umfasst die Magnesiumlegierung Yttrium (Y) in einer Menge von 3.5 bis 4.5 Gew.-%, bezogen auf das Gesamtgewicht der Magnesiumlegierung.

Um eine Magnesiumlegierung mit guten mechanischen Eigenschaften bei erhöhten Temperaturen sowie einer verbesserten Entzündungs- und Flammbeständigkeit zu erhalten, ist es vorteilhaft, dass die Magnesiumlegierung zusätzlich oder alternativ Zirkonium (Zr) als mindestens eine weitere Legierungskomponente umfasst.

Umfasst die Magnesiumlegierung Zirkonium (Zr) als mindestens eine weitere Legierungskomponente, umfasst die Magnesiumlegierung Zirkonium (Zr) vorzugsweise in einer Menge von 0.05 bis 6 Gew.-%, bezogen auf das Gesamtgewicht der Magnesiumlegierung. Beispielsweise umfasst die Magnesiumlegierung Zirkonium (Zr) in einer Menge von 0.1 bis 5.5 Gew.-%, bezogen auf das Gesamtgewicht der Magnesiumlegierung. In einer Ausführungsform umfasst die Magnesiumlegierung Zirkonium (Zr) in einer Menge von 0.2 bis 1 Gew.-%, bezogen auf das Gesamtgewicht der Magnesiumlegierung. In einer bevorzugten Ausführungsform umfasst die Magnesiumlegierung Zirkonium (Zr) in einer Menge von 0.2 bis 0.5 Gew.-%, bezogen auf das Gesamtgewicht der Magnesiumlegierung.

Um eine Magnesiumlegierung mit guten mechanischen Eigenschaften bei erhöhten Temperaturen sowie einer verbesserten Entzündungs- und Flammbeständigkeit zu erhalten, ist es vorteilhaft, dass die Magnesiumlegierung zusätzlich oder alternativ Neodym (Nd) als mindestens eine weitere Legierungskomponente umfasst.

Umfasst die Magnesiumlegierung Neodym (Nd) als mindestens eine weitere Legierungskomponente, umfasst die Magnesiumlegierung Neodym (Nd) vorzugsweise in einer Menge von 0.05 bis 6 Gew.-%, bezogen auf das Gesamtgewicht der Magnesiumlegierung. Beispielsweise umfasst die Magnesiumlegierung Neodym (Nd) in einer Menge von 0.1 bis 5.5 Gew.-%, bezogen auf das Gesamtgewicht der Magnesiumlegierung. In einer Ausführungsform umfasst die Magnesiumlegierung Neodym (Nd) in einer Menge von 0.5 bis 3.5 Gew.-%, bezogen auf das Gesamtgewicht der Magnesiumlegierung. Beispielsweise umfasst die Magnesiumlegierung Neodym (Nd) in einer Menge von 1.5 bis 2 Gew.-%, bezogen auf das Gesamtgewicht der Magnesiumlegierung. Alternativ umfasst die Magnesiumlegierung Neodym (Nd) in einer Menge von 2.5 bis 3.2 Gew.-%, bezogen auf das Gesamtgewicht der Magnesiumlegierung.

Beispielsweise umfasst die Magnesiumlegierung Yttrium (Y) und Zirkonium (Zr) als weitere Legierungskomponente. In dieser Ausführungsform umfasst die Magnesiumlegierung Yttrium (Y) und Zirkonium (Zr) in einer Gesamtmenge von 2 bis 15 Gew.-%, bezogen auf das Gesamtgewicht der Magnesiumlegierung. In einer Ausführungsform umfasst die Magnesiumlegierung Yttrium (Y) und Zirkonium (Zr) vorzugsweise in einer Gesamtmenge von 2 bis 10 Gew.-%, bezogen auf das Gesamtgewicht der Magnesiumlegierung. In einer bevorzugten Ausführungsform umfasst die Magnesiumlegierung Yttrium (Y) und Zirkonium (Zr) vorzugsweise in einer Gesamtmenge von 3.5 bis 6 Gew.-%, bezogen auf das Gesamtgewicht der Magnesiumlegierung.

Beispielsweise umfasst die Magnesiumlegierung Yttrium (Y) und Zirkonium (Zr) in einer Gesamtmenge von 5.1 bis 6 Gew.-%, bezogen auf das Gesamtgewicht der Magnesiumlegierung. In dieser Ausführungsform umfasst die Magnesiumlegierung Yttrium (Y) vorzugsweise in einer Menge von 4.75 bis 5.5 Gew.-% und Zirkonium (Zr) in einer Menge von 0.35 bis 0.5 Gew.-%, bezogen auf das Gesamtgewicht der Magnesiumlegierung.

Alternativ umfasst die Magnesiumlegierung Yttrium (Y) und Zirkonium (Zr) in einer Gesamtmenge von 3.8 bis 5 Gew.-%, bezogen auf das Gesamtgewicht der Magnesiumlegierung. In dieser Ausführungsform umfasst die Magnesiumlegierung Yttrium (Y) vorzugsweise in einer Menge von 3.7 bis 4.3 Gew.-% und Zirkonium (Zr) in einer Menge von 0.1 bis 0.7 Gew.-%, bezogen auf das Gesamtgewicht der Magnesiumlegierung.

In einer Ausführungsform umfasst die Magnesiumlegierung Yttrium (Y), Neodym (Nd) und Zirkonium (Zr) als weitere Legierungskomponente. In dieser Ausführungsform umfasst die Magnesiumlegierung Yttrium (Y), Neodym (Nd) und Zirkonium (Zr) in einer Gesamtmenge von 2 bis 15 Gew.-%, bezogen auf das Gesamtgewicht der Magnesiumlegierung. In einer Ausführungsform umfasst die Magnesiumlegierung Yttrium (Y), Neodym (Nd) und Zirkonium (Zr) vorzugsweise in einer Gesamtmenge von 2 bis 10 Gew.-%, bezogen auf das Gesamtgewicht der Magnesiumlegierung. In einer bevorzugten Ausführungsform umfasst die Magnesiumlegierung Yttrium (Y), Neodym (Nd) und Zirkonium (Zr) vorzugsweise in einer Gesamtmenge von 3.5 bis 8 Gew.-%, bezogen auf das Gesamtgewicht der Magnesiumlegierung.

Beispielsweise umfasst die Magnesiumlegierung Yttrium (Y), Neodym (Nd) und Zirkonium (Zr) in einer Gesamtmenge von 5 bis 8 Gew.-%, bezogen auf das Gesamtgewicht der Magnesiumlegierung.

Alternativ umfasst die Magnesiumlegierung Yttrium (Y), Neodym (Nd) und Zirkonium (Zr) in einer Gesamtmenge von 6.6 bis 8 Gew.-%, bezogen auf das Gesamtgewicht der Magnesiumlegierung. In dieser Ausführungsform umfasst die Magnesiumlegierung Yttrium (Y) vorzugsweise in einer Menge von 4.75 bis 5.5 Gew.-%, Zirkonium (Zr) in einer Menge von 0.35 bis 0.5 Gew.-% und Neodym (Nd) in einer Menge von 1.5 bis 2 Gew.-%, bezogen auf das Gesamtgewicht der Magnesiumlegierung.

Herstellungsbedingt kann die Magnesiumlegierung Verunreinigungen anderer Elemente aufweisen, d.h. Elemente, die nicht ausgewählt sind aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Zirkonium (Zr), Zink (Zn), Gadolinium (Gd), Scandium (Sc), Lanthan (La), Cer (Ce), Praseodym (Pr), Promethium (Pm), Samarium (Sm), Europium (Eu), Aluminium (AI), Calcium (Ca), Silicium (Si), Mangan (Mn), Lithium (Li), Silber (Ag) oder Mischungen hiervon. Beispielsweise umfasst die Magnesiumlegierung Verunreinigungen in einer Menge von 0.01 bis 1.0 Gew.-% pro Element, bezogen auf das Gesamtgewicht der Magnesiumlegierung.

Solche Verunreinigungen können beispielsweise ausgewählt sein aus der Gruppe umfassend Eisen (Fe), Kupfer (Cu) und/oder Nickel (Ni).

Zusätzlich oder alternativ umfasst die Magnesiumlegierung Verunreinigungen in Summe maximal in einer Menge von 10 Gew.-%, bezogen auf das Gesamtgewicht der Magnesiumlegierung. Beispielsweise umfasst die Magnesiumlegierung die Verunreinigungen in Summe in einer Menge von 0.05 bis 2 Gew.-%, bevorzugt von 0.5 bis 2 Gew.-% und am meisten bevorzugt von 0.55 bis 2 Gew.-%, bezogen auf das Gesamtgewicht der Magnesiumlegierung.

Magnesiumlegierungen des erfindungsgemäßen Kompositwerkstoffs sind im Stand der Technik bekannt und können durch bekannte Herstellungsverfahren erhalten werden. Beispielsweise sind solche Magnesiumlegierungen unter der Bezeichnung WE43, WE54, ZE41, ZE10 oder Elektron 21 von Magnesium Elektron, UK, kommerziell erhältlich.

Ein weiteres Erfordernis der vorliegenden Erfindung ist, dass der Kompositwerkstoff eine Schicht bestehend aus nanoskaligen Graphen-Plättchen auf mindestens einem Teil der Oberfläche der Magnesiumlegierung aufweist. Unter "nanoskaligen" Graphen-Plättchen sind gemäß der vorliegenden Erfindung nanoskalige Graphen-Plättchen mit eine Länge, Breite oder Durchmesser im Nanometer- bis in den unteren Mikrometerbereich zu verstehen. In einer Ausführungsform weisen die nanoskaligen Graphen-Plättchen eine Länge, Breite oder Durchmesser von ≤ 100 µm auf. Beispielsweise weisen die nanoskaligen Graphen-Plättchen eine Länge, Breite oder Durchmesser von ≤ 50 µm, auf. In einer Ausführungsform weisen die nanoskaligen Graphen-Plättchen eine Länge, Breite oder Durchmesser von 1 bis 100 µm.

Erfindungsgemäß weisen die nanoskaligen Graphen-Plättchen eine Dicke von 1 bis 100 nm auf.

Beispielsweise weisen die nanoskaligen Graphen-Plättchen eine Dicke von 1 bis 100 nm und eine Länge, Breite oder Durchmesser von ≤ 100 µm, vorzugsweise von ≤ 50 µm, auf. In einer Ausführungsform weisen die nanoskaligen Graphen-Plättchen eine Dicke von 1 bis 100 nm und eine Länge, Breite oder Durchmesser von 1 bis 100 µm auf. Die Verwendung von nanoskaligen Graphen-Plättchen hat den Vorteil, dass diese auf der Magnesiumlegierung enger als z.B. CNTs gepackt werden können und somit die Oberfläche der Magnesiumlegierung im Wesentlichen vollständig beschichtet werden kann.

Beispielsweise sind die nanoskaligen Graphen-Plättchen planar, sphärisch, nicht-sphärisch oder Mischungen hiervon. Vorzugsweise, sind die nanoskaligen Graphen-Plättchen nicht-sphärisch, beispielsweise sind die nanoskaligen Graphen-Plättchen planar.

Planare Graphen-Plättchen haben üblicherweise ein Verhältnis Dicke/Länge oder Breite von 10 bis 1000, vorzugsweise von 100 bis 500.

Nicht-sphärische Nanopartikel liegen bei einem Aspektverhältnis vor, der sich von sphärischen Partikeln unterscheidet, d.h. das Aspektverhältnis der nicht-sphärischen Nanopartikel ist nicht von 1.0 bis 2.0. Liegen die nanoskaligen Graphen-Plättchen als nicht-sphärische Partikel vor, bezieht sich der Durchmesser der nanoskaligen Graphen-Plättchen vorzugsweise auf die kürzere Dimension.

Für den Kompositwerkstoff ist es besonders vorteilhaft, wenn dieser eine Schicht bestehend aus nanoskaligen Graphen-Plättchen auf mindestens einem Teil der Oberfläche der Magnesiumlegierung umfasst. Hierdurch kann insbesondere das Brandrisiko verringert und die Abriebs- und Degradierungsbeständigkeit, im Vergleich zu herkömmlichen Magnesiumlegierungen, verbessert werden.

Insbesondere ist es vorteilhaft, wenn mindestens 50 % der Oberfläche der Magnesiumlegierung mit einer Schicht bestehend aus nanoskaligen Graphen-Plättchen beschichtet ist. Beispielsweise ist mindestens 70 %, bevorzugter mindestens 80 %, noch bevorzugter mindestens 90 %, noch weiter bevorzugt mindestens 95 % und am meisten bevorzugt mindestens 98 % der Oberfläche der Magnesiumlegierung mit einer Schicht bestehend aus nanoskaligen Graphen-Plättchen beschichtet ist. In einer Ausführungsform ist im Wesentlichen die gesamte Oberfläche der Magnesiumlegierung mit einer Schicht bestehend aus nanoskaligen Graphen-Plättchen beschichtet.

Es ist vorteilhaft, wenn die Schicht bestehend aus nanoskaligen Graphen-Plättchen im Wesentlichen frei von Poren ist.

In einer Ausführungsform der vorliegenden Erfindung ist im Wesentlichen die gesamte Oberfläche mit Graphen-Plättchen bedeckt und die Schicht bestehend aus nanoskaligen Graphen-Plättchen ist im Wesentlichen frei von Poren.

Für den Kompositwerkstoff ist es besonders vorteilhaft, wenn die Schicht bestehend aus nanoskaligen Graphen-Plättchen homogen auf der Magnesiumlegierung verteilt ist.

Alternativ kann die Schicht bestehend aus nanoskaligen Graphen-Plättchen inhomogen auf der Magnesiumlegierung verteilt sein.

In einer Ausführungsform liegt die Schicht bestehend aus nanoskaligen Graphen-Plättchen im Wesentlichen auf der gesamten Oberfläche der Magnesiumlegierung vor. Dies ist besonders vorteilhaft zur Verbesserung der mechanischen Eigenschaften, insbesondere der Festigkeit, und chemischen Eigenschaften, insbesondere der Flamm- und Korrosionsbeständigkeit. Des Weiteren kann hierdurch das Brandrisiko verringert und die Abriebs- und Degradierungsbeständigkeit, im Vergleich zu herkömmlichen Magnesiumlegierungen, verbessert werden.

Des Weiteren ist es für die mechanischen und chemischen Eigenschaften vorteilhaft, wenn die Schicht bestehend aus nanoskaligen Graphen-Plättchen eine Schichtdicke von 10 nm nicht unterschreitet. Weiterhin stellt sich keine wesentliche Verbesserung bezüglich der mechanischen und chemischen Eigenschaften ein, wenn die Schicht bestehend aus nanoskaligen Graphen-Plättchen eine Schichtdicke von mehr als 1 000 nm aufweist. Daher weist die Schicht bestehend aus nanoskaligen Graphen-Plättchen vorzugsweise eine Schichtdicke von 10 bis 1 000 nm auf. Beispielsweise weist die Schicht bestehend aus nanoskaligen Graphen-Plättchen vorzugsweise eine Schichtdicke von 10 bis 500 nm auf.

Die Schichtdicke der Schicht bestehend aus nanoskaligen Graphen-Plättchen bezieht sich vorzugsweise auf die durchschnittliche Schichtdicke.

In einer Ausführungsform besteht die Schicht bestehend aus nanoskaligen Graphen-Plättchen aus mehreren Schichten. Beispielsweise besteht die Schicht bestehend aus nanoskaligen Graphen-Plättchen aus zwei, oder drei, oder vier Schichten. Vorzugsweise besteht die Schicht bestehend aus nanoskaligen Graphen-Plättchen aus zwei oder drei Schichten, noch bevorzugter aus zwei Schichten. Die Schicht bestehend aus nanoskaligen Graphen-Plättchen weist vorzugsweise eine Gesamtschichtdicke von 10 bis 1 000 nm auf. Beispielsweise weist die Schicht bestehend aus nanoskaligen Graphen-Plättchen eine Gesamtschichtdicke von 10 bis 500 nm auf.

In einer Ausführungsform ist die Schicht bestehend aus nanoskaligen Graphen-Plättchen auf mindestens einem Teil der Oberfläche der Magnesiumlegierung direkt auf der Magnesiumlegierung aufgebracht.

Die nanoskaligen Graphen-Plättchen können durch mechanische oder chemische Verfahren erhalten werden.

Werden die nanoskaligen Graphen-Plättchen durch mechanische Verfahren erhalten, werden die nanoskaligen Graphen-Plättchen vorzugsweise durch Exfoliation, Wegbrennen des Si bei SiC-Kristall, Abschuppen oder Plättchentrennung aus einem natürlichen Graphit, synthetischen Graphit, hochorientierten pyrolytischen Graphit, Kohlenstoff-Nanofasern, Graphit-Nanofasern, kugelförmigen Graphit, Mesophasen-Pech, Graphit-Koks, oder Mischungen hiervon erhalten.

Alternativ werden die nanoskaligen Graphen-Plättchen durch chemische Verfahren wie beispielsweise durch Reduktion von Graphenoxid, oder auch durch epitaktisches Wachstum erhalten.

Die Schicht bestehend aus nanoskaligen Graphen-Plättchen hat vorzugsweise
a) eine thermische Leitfähigkeit von ≥ 1 Wm⁻¹K⁻¹, und/oder
b) eine Schmelztemperatur von ≥3725 °C, und/oder
c) eine Zugfestigkeit von 1 bis 10 GPa, und/oder
d) eine elektrische Leitfähigkeit von ≤ 10⁷ Ω⁻¹ cm⁻¹.

In einer Ausführungsform hat die Schicht bestehend aus nanoskaligen Graphen-Plättchen eine thermische Leitfähigkeit von ≥ 1 Wm⁻¹K⁻¹, bevorzugt von ≥ 100 Wm⁻¹K⁻¹, weiter bevorzugt von ≥ 250 Wm⁻¹K⁻¹, am meisten bevorzugt in einem Bereich von 1 bis 5 000 Wm⁻¹K⁻¹, beispielsweise von 1 bis 4 000 Wm⁻¹K⁻¹. Wenn nicht anders angegeben, wurde die thermische Leitfähigkeit gemäß ASTM E1461 bestimmt.

Zusätzlich oder alternativ hat die Schicht bestehend aus nanoskaligen Graphen-Plättchen eine Schmelztemperatur von ≥ 3725 °C, bevorzugt von ≥ 4000 °C, weiter bevorzugt von ≥ 4500 °C, am meisten bevorzugt in einem Bereich von 4500 bis 5000 °C. Wenn nicht anders angegeben, wurde die Schmelztemperatur gemäß ASTM D3418 bestimmt.

Zusätzlich oder alternativ hat die Schicht bestehend aus nanoskaligen Graphen-Plättchen eine Zugfestigkeit von 1 bis 10 GPa, bevorzugt von 1 bis 8 GPa, weiter bevorzugt von 2 bis 8 GPa, am meisten bevorzugt von 3 bis 8 GPa. Die Zugfestigkeit wurde, wenn nicht anders angegeben, gemäß ASTM 638 bestimmt.

Zusätzlich oder alternativ hat die Schicht bestehend aus nanoskaligen Graphen-Plättchen eine elektrische Leitfähigkeit von ≤ 10⁷ Ω⁻¹ cm⁻¹ und bevorzugt in einem Bereich von 10³ bis 10⁷ Ω⁻¹ cm⁻¹. Wenn nicht anders angegeben, wurde die elektrische Leitfähigkeit gemäß ASTM D 257 bestimmt.

Beispielsweise hat die Schicht bestehend aus nanoskaligen Graphen-Plättchen
a) eine thermische Leitfähigkeit von ≥ 1 Wm⁻¹K⁻¹, bevorzugt von ≥ 100 Wm⁻¹K⁻¹, weiter bevorzugt von ≥ 250 Wm⁻¹K⁻¹, am meisten bevorzugt in einem Bereich von 1 bis 5 000 Wm⁻¹K⁻¹, beispielsweise von 1 bis 4 000 Wm⁻¹K⁻¹, oder
b) eine Schmelztemperatur von ≥ 3725 °C, bevorzugt von ≥ 4000 °C, weiter bevorzugt von ≥ 4500 °C, am meisten bevorzugt in einem Bereich von 4500 bis 5000 °C, oder
c) eine Zugfestigkeit von 1 bis 10 GPa, bevorzugt von 1 bis 8 GPa, weiter bevorzugt von 2 bis 8 GPa, am meisten bevorzugt von 3 bis 8 GPa, oder
d) eine elektrische Leitfähigkeit von ≤ 10⁷ Ω⁻¹ cm⁻¹, bevorzugt in einem Bereich von 10³ bis 10⁷ Ω⁻¹ cm⁻¹.

Alternativ hat die Schicht bestehend aus nanoskaligen Graphen-Plättchen
a) eine thermische Leitfähigkeit von ≥ 1 Wm⁻¹K⁻¹, bevorzugt von ≥ 100 Wm⁻¹K⁻¹, weiter bevorzugt von ≥ 250 Wm⁻¹K⁻¹, am meisten bevorzugt in einem Bereich von 1 bis 5 000 Wm⁻¹K⁻¹, beispielsweise von 1 bis 4 000 Wm⁻¹K^{-1,} und
b) eine Schmelztemperatur von ≥ 3725 °C, bevorzugt von ≥ 4000 °C, weiter bevorzugt von ≥ 4500 °C, am meisten bevorzugt in einem Bereich von 4500 bis 5000 °C, und
c) eine Zugfestigkeit von 1 bis 10 GPa, bevorzugt von 1 bis 8 GPa, weiter bevorzugt von 2 bis 8 GPa, am meisten bevorzugt von 3 bis 8 GPa, und
d) eine elektrische Leitfähigkeit von ≤ 10⁷ Ω⁻¹ cm⁻¹, bevorzugt in einem Bereich von 10³ bis 10⁷ Ω⁻¹ cm⁻¹.

Der erfindungsgemäße Kompositwerkstoff weist verbesserte mechanische Eigenschaften, insbesondere eine verbesserte Festigkeit, und chemische Eigenschaften, insbesondere eine verbesserte Flamm- und Korrosionsbeständigkeit, auf. Ferner weist der Kompositwerkstoff ein geringeres Brandrisiko und eine verbesserte Abriebs- und Degradierungsbeständigkeit, im Vergleich zu herkömmlichen Magnesiumlegierungen, auf. Darüber hinaus weist der Kompositwerkstoff, im Vergleich zu herkömmlichen Aluminiumlegierungen, ein geringeres Gewicht auf und ist somit insbesondere als Werkstoff in Luftfahrzeugen geeignet.

Die vorliegende Erfindung betrifft auch ein Verfahren zur Herstellung eines solchen Kompositwerkstoffes. Der Kompositwerkstoff wird vorzugsweise durch ein Verfahren, wie nachfolgend beschrieben, hergestellt.

Das erfindungsgemäße Verfahren zur Herstellung des Kompositwerkstoffes, wie vorstehend beschrieben, umfasst mindestens die Schritte:
a) Bereitstellen einer Magnesiumlegierung, wie hierin definiert,
b) Bereitstellen von nanoskaligen Graphen-Plättchen, wie hierin definiert,
c) Aufbringen der nanoskaligen Graphen-Plättchen aus Schritt b) auf mindestens einem Teil der Oberfläche der Magnesiumlegierung aus Schritt a) zur Herstellung eines Kompositwerkstoffes.

Das erfindungsgemäße Verfahren eignet sich zur Herstellung des oben-genannten Kompositwerkstoffes und weist einen niedrigen Fertigungsaufwand auf bei gleichzeitiger Verbesserung der mechanischen und chemischen Eigenschaften. Gemäß Schritt a) ist somit ein Erfordernis des erfindungsgemäßen Verfahrens, dass eine Magnesiumlegierung bereitgestellt wird.

Bzgl. der Magnesiumlegierung, der weiteren Legierungskomponenten und deren Mengen in der Magnesiumlegierung, wird auf die obigen Definitionen mit Bezug auf die Magnesiumlegierung und deren Ausführungsformen verwiesen.

Zur Verminderung einer Kontaktkorrosion zwischen der Oberfläche der Magnesiumlegierung und der Schicht bestehend aus nanoskaligen Graphen-Plättchen und einer Verbesserung der Haftung der Schicht bestehend aus nanoskaligen Graphen-Plättchen auf der Oberfläche der Magnesiumlegierung, ist es vorteilhaft, wenn die Oberfläche der Magnesiumlegierung vorbehandelt wird.

In einer Ausführungsform wird die Magnesiumlegierung durch Aufbringen einer organischen oder anorganischen Beschichtung vorbehandelt. Falls vorhanden, erfolgt die Vorbehandlung der Oberfläche der Magnesiumlegierung vor Schritt c).

Vorzugsweise erfolgt die Vorbehandlung der Oberfläche der Magnesiumlegierung durch Aufbringen einer organischen oder anorganischen Beschichtung auf der Magnesiumlegierung, die zu einer geringeren Oberflächenleitfähigkeit der vorbeschichteten Legierung führt. Dazu kann beispielsweise eine organische Beschichtung, oder eine anorganische Beschichtung auf die Oberfläche der Magnesiumlegierung aufgebracht werden. Solche Verfahren zur Vorbehandlung und entsprechende Beschichtungen sind aus dem Stand der Technik bekannt, wie beispielsweise Ardrox 1769 oder Oxsilan 9802 der Chemetall GmbH, Deutschland. In einer Ausführungsform kann die Oberfläche der Magnesiumlegierung nach dem Aufbringen der organischen oder anorganischen Beschichtung mit Wasser gespült werden.

In einer Ausführungsform wird die Oberfläche der Magnesiumlegierung vor dem Aufbringen der Beschichtung gereinigt. Entsprechende Reinigungsschritte sind aus dem Stand der Technik bekannt. Beispielsweise kann die Oberfläche der Magnesiumlegierung vor dem Aufbringen der organischen oder anorganischen Beschichtung durch Behandlung mit einem alkalischen Reiniger, Spülen mit Wasser, Behandlung mit einem sauren Reiniger und Spülen mit Wasser gereinigt werden. Entsprechende alkalische und saure Reiniger sind aus dem Stand der Technik bekannt.

Gemäß Schritt b) des erfindungsgemäßen Verfahrens werden nanoskalige Graphen-Plättchen bereitgestellt.

Bzgl. der nanoskaligen Graphen-Plättchen wird auf die obigen Definitionen mit Bezug auf die nanoskaligen Graphen-Plättchen und deren Ausführungsformen verwiesen.

Gemäß Schritt c) ist ein weiteres Erfordernis des erfindungsgemäßen Verfahrens, dass die nanoskaligen Graphen-Plättchen aus Schritt b) auf mindestens einem Teil der Oberfläche der Magnesiumlegierung aus Schritt a) zur Herstellung eines Kompositwerkstoffes aufgebracht werden.

Das Aufbringen der nanoskaligen Graphen-Plättchen auf mindestens einem Teil der Oberfläche der Magnesiumlegierung in Schritt c) kann durch eine Vielzahl unterschiedlicher Verfahren erfolgen. Üblicherweise erfolgt das Aufbringen der nanoskaligen Graphen-Plättchen auf mindestens einem Teil der Oberfläche der Magnesiumlegierung in Schritt c) durch chemische Gasphasenabscheidung (CVD), epitaktisches Wachstum oder Abscheidung aus einer organischen Matrix. Verfahren zur chemischen Gasphasenabscheidung (CVD), epitaktischem Wachstum oder Abscheidung aus einer organischen Matrix sind im Stand der Technik bekannt.

Erfolgt das Aufbringen der nanoskaligen Graphen-Plättchen auf mindestens einem Teil der Oberfläche der Magnesiumlegierung in Schritt c) durch Abscheidung aus einer organischen Matrix, kann nach dem Aufbringen der nanoskaligen Graphen-Plättchen in Schritt c) eine thermische Weiterbehandlung zum Wiederherstellen der intrinsischen Eigenschaften des Graphens und zum Aushärten der Schicht bestehend aus nanoskaligen Graphen-Plättchen auf der Oberfläche der Magnesiumlegierung erfolgen.

Vorzugsweise erfolgt die thermische Weiterbehandlung in einem Temperaturbereich von 100 bis 500°C in Abhängigkeit von der verwendeten organischen Matrix. Beispielsweise erfolgt die thermische Weiterbehandlung in einem Temperaturbereich von 100 bis 300°C.

In einer Ausführungsform der vorliegenden Erfindung erfolgt die thermische Weiterbehandlung in einem Temperaturbereich von 100 bis 500°C, beispielsweise in einem Temperaturbereich von 100 bis 300°C für eine Dauer von 10 min bis 50 h. Die thermische Weiterbehandlung kann typischerweise bei Temperaturen zwischen 100 bis 500°C, beispielsweise in einem Temperaturbereich von 100 bis 300 °C für eine Dauer von 10 min bis 10 h erfolgen. Beispielsweise erfolgt die thermische Weiterbehandlung bei Temperaturen zwischen 100 bis 500°C, beispielsweise in einem Temperaturbereich von 100 bis 300°C für eine Dauer von 10 min bis 5 h oder für eine Dauer von 30 min bis 3 h. Beispielsweise kann die thermische Weiterbehandlung unter Luft, Schutzgas oder im Vakuum erfolgen, beispielsweise im Vakuum.

Verfahren zur thermische Weiterbehandlung von Kompositwerkstoffen in einem Temperaturbereich von 100 bis 500°C sind im Stand der Technik bekannt.

Aufgrund der Vorteile, die der erfindungsgemäße Kompositwerkstoff bietet, betrifft die vorliegende Erfindung auch die Verwendung des Kompositwerkstoffes in einem Passagiertransportfahrzeug, Hubschrauber oder einem unbemannten Luftfahrzeug, in einem Raumfahrzeug, Transportfahrzeug, insbesondere in Bahnen und Schiffen, im Automobilbau, Anlagenbau, Maschinenbau oder Werkzeugbau. Beispielsweise kann der erfindungsgemäße Kompositwerkstoff in Luftfahrzeugen wie Passagierflugzeugen verwendet werden. Insbesondere wird der erfindungsgemäße Kompositwerkstoff in einer Flugzeugzelle verwendet.

## Patentansprüche

1. Kompositwerkstoff umfassend
a) eine Magnesiumlegierung, und
b) eine Schicht bestehend aus nanoskaligen Graphen-Plättchen auf mindestens einem Teil der Oberfläche der Magnesiumlegierung,
wobei die Magnesiumlegierung als weitere Legierungskomponente mindestens eine Komponente ausgewählt aus der Gruppe umfassend Yttrium (Y), Neodym (Nd), Terbium (Tb), Dysprosium (Dy), Holmium (Ho), Erbium (Er), Thulium (Tm), Ytterbium (Yb), Lutetium (Lu), Gadolinium (Gd), Scandium (Sc), Lanthan (La), Cer (Ce), Praseodym (Pr), Promethium (Pm), Samarium (Sm), Europium (Er) oder Mischungen hiervon umfasst, und
wobei die nanoskaligen Graphen-Plättchen eine Dicke von 1 bis 100 nm aufweisen.

2. Der Kompositwerkstoff gemäß Anspruch 1, wobei die Magnesiumlegierung Magnesium in einer Menge von 80 bis 98 Gew.-%, bezogen auf das Gesamtgewicht der Magnesiumlegierung, umfasst.

3. Der Kompositwerkstoff gemäß Anspruch 1 oder 2, wobei die Schicht bestehend aus nanoskaligen Graphen-Plättchen im Wesentlichen auf der gesamten Oberfläche der Magnesiumlegierung vorliegt.

4. Der Kompositwerkstoff gemäß einem der vorherigen Ansprüche, wobei die Schicht bestehend aus nanoskaligen Graphen-Plättchen eine Schichtdicke von 10 bis 1 000 nm aufweist.

5. Der Kompositwerkstoff gemäß einem der vorherigen Ansprüche, wobei die Schicht bestehend aus nanoskaligen Graphen-Plättchen aus mehreren Schichten besteht.

6. Der Kompositwerkstoff gemäß einem der vorherigen Ansprüche, wobei die nanoskaligen Graphen-Plättchen eine Länge, Breite oder Durchmesser von ≤ 100 µm aufweisen.

7. Der Kompositwerkstoff gemäß einem der vorherigen Ansprüche, wobei die nanoskaligen Graphen-Plättchen durch mechanische oder chemische Verfahren erhalten werden.

8. Der Kompositwerkstoff gemäß einem der vorherigen Ansprüche, wobei die Schicht bestehend aus nanoskaligen Graphen-Plättchen
a) eine thermische Leitfähigkeit von ≥ 1Wm⁻¹K⁻¹ aufweist, und/oder
b) eine Schmelztemperatur von ≥ 3725 °C aufweist, und/oder
c) eine Zugfestigkeit von 1 bis 10 GPa, und/oder
d) eine elektrische Leitfähigkeit von ≤ 10⁷ Ω⁻¹ cm⁻¹ aufweist.

9. Der Kompositwerkstoff gemäß einem der vorherigen Ansprüche, wobei der Kompositwerkstoff durch ein Verfahren gemäß einem der Ansprüche 10 bis 12 erhalten wird.

10. Verfahren zur Herstellung eines Kompositwerkstoffes gemäß einem der Ansprüche 1 bis 8, das Verfahren umfassend
a) Bereitstellen einer Magnesiumlegierung, wie in einem der Ansprüche 1 und 2 definiert,
b) Bereitstellen von nanoskaligen Graphen-Plättchen, wie in einem der Ansprüche 1, 6 oder 7 definiert,
c) Aufbringen der nanoskaligen Graphen-Plättchen aus Schritt b) auf mindestens einem Teil der Oberfläche der Magnesiumlegierung aus Schritt a) zur Herstellung eines Kompositwerkstoffes.

11. Verfahren gemäß Anspruch 10, wobei das Aufbringen der nanoskaligen Graphen-Plättchen auf mindestens einem Teil der Oberfläche der Magnesiumlegierung in Schritt c) durch chemische Gasphasenabscheidung (CVD), epitaktisches Wachstum oder Abscheidung aus einer organischen Matrix erfolgt.

12. Verfahren gemäß Anspruch 10 oder 11, wobei die Magnesiumlegierung vor Schritt c) durch Aufbringen einer organischen oder anorganischen Beschichtung, die zu einer geringeren Oberflächenleitfähigkeit der Magnesiumlegierung führen kann, vorbehandelt wird.

13. Verwendung eines Kompositwerkstoffes gemäß einem der Ansprüche 1 bis 9 in einem Passagiertransportfahrzeug, insbesondere in Luftfahrzeugen wie Passagierflugzeugen, Hubschrauber oder einem unbemannten Luftfahrzeug, in einem Raumfahrzeug, Transportfahrzeug, insbesondere in Bahnen und Schiffen, im Automobilbau, Anlagenbau, Maschinenbau oder Werkzeugbau.

14. Verwendung gemäß Anspruch 13 in einer Flugzeugzelle.

## Claims

1. Composite material comprising
a) a magnesium alloy and
b) a layer consisting of nanosize graphene platelets on at least part of the surface of the magnesium alloy,
wherein the magnesium alloy comprises at least one component selected from the group consisting of yttrium (Y), neodymium (Nd), terbium (Tb), dysprosium (Dy), holmium (Ho), erbium (Er), thulium (Tm), ytterbium (Yb), lutetium (Lu), gadolinium (Gd), scandium (Sc), lanthanum (La), cerium (Ce), praseodymium (Pr), promethium (Pm), samarium (Sm), europium (Er) and mixtures thereof as further alloy component and
the nanosize graphene platelets have a thickness of from 1 to 100 nm.

2. Composite material according to Claim 1, wherein the magnesium alloy comprises magnesium in an amount of from 80 to 98% by weight, based on the total weight of the magnesium alloy.

3. Composite material according to Claim 1 or 2, wherein the layer consisting of nanosize graphene platelets is present on essentially the entire surface of the magnesium alloy.

4. Composite material according to any of the preceding claims, wherein the layer consisting of nanosize graphene platelets has a layer thickness of from 10 to 1000 nm.

5. Composite material according to any of the preceding claims, wherein the layer consisting of nanosize graphene platelets consists of a plurality of layers.

6. Composite material according to any of the preceding claims, wherein the nanosize graphene platelets have a length, width or diameter of ≤ 100 µm.

7. Composite material according to any of the preceding claims, wherein the nanosize graphene platelets are obtained by mechanical or chemical processes.

8. Composite material according to any of the preceding claims, wherein the layer consisting of nanosize graphene platelets
a) has a thermal conductivity of ≥ 1 Wm⁻¹K⁻¹, and/or
b) has a melting point of ≥ 3725°C, and/or
c) has a tensile strength of from 1 to 10 GPa, and/or
d) has an electrical conductivity of ≤ 10⁷ Q⁻¹ cm⁻¹.

9. Composite material according to any of the preceding claims, wherein the composite material is obtained by a process according to any of Claims 10 to 12.

10. Process for producing a composite material according to any of Claims 1 to 8, which process comprises
a) provision of a magnesium alloy as defined in either Claim 1 or 2,
b) provision of nanosize graphene platelets as defined in any of Claims 1, 6 or 7,
c) application of the nanosize graphene platelets from step b) to at least part of the surface of the magnesium alloy from step a) to produce a composite material.

11. Process according to Claim 10, wherein the application of the nanosize graphene platelets to at least part of the surface of the magnesium alloy in step c) is carried out by chemical vapour deposition (CVD), epitactic growth or deposition from an organic matrix.

12. Process according to Claim 10 or 11, wherein the magnesium alloy is pretreated before step c) by application of an organic or inorganic coating which can lead to a lower surface conductivity of the magnesium alloy.

13. Use of a composite material according to any of Claims 1 to 9 in a passenger transport vehicle, in particular in aircraft such as passenger aircraft, helicopters or an unmanned aircraft, in a spacecraft, transport vehicle, in particular in trains and ships, in automobile construction, plant construction, machine construction or toolmaking.

14. Use according to Claim 13 in an aircraft cell.

## Revendications

1. Matériau composite, comprenant
a) un alliage de magnésium et
b) une couche composée de plaquettes de graphène à l'échelle nanométrique sur au moins une partie de la surface de l'alliage de magnésium,
l'alliage de magnésium comprenant en tant que composant d'alliage supplémentaire, au moins un composant choisi dans le groupe comprenant l'yttrium (Y), le néodyme (Nd), le terbium (Tb), le dysprosium (Dy), l'holmium (Ho), l'erbium (Er), le thulium (Tm) , l'ytterbium (Yb), le lutétium (Lu), le gadolinium (Gd), le scandium (Sc), le lanthane (La), le cérium (Ce), le praséodyme (Pr), le prométhium (Pm), le samarium (Sm), l'europium (Er) ou des mélanges de ceux-ci, et
les plaquettes de graphène à l'échelle nanométrique présentant une épaisseur de 1 à 100 nm.

2. Matériau composite selon la revendication 1, l'alliage de magnésium comprenant du magnésium dans une quantité de 80 à 98 % massiques en référence au poids total de l'alliage de magnésium.

3. Matériau composite selon la revendication 1 ou 2, la couche composée de plaquettes de graphène à l'échelle nanométrique étant présente sensiblement sur la totalité de la surface de l'alliage de magnésium.

4. Matériau composite selon l'une des revendications précédentes, la couche composée de plaquettes de graphène à l'échelle nanométrique présentant une épaisseur de couche de 10 à 1000 nm.

5. Matériau composite selon l'une des revendications précédentes, la couche composée de plaquettes de graphène à l'échelle nanométrique étant constituée de plusieurs couches.

6. Matériau composite selon l'une des revendications précédentes, les plaquettes de graphène à l'échelle nanométrique présentant une longueur, une largeur ou un diamètre ≤ 100 µm.

7. Matériau composite selon l'une des revendications précédentes, les plaquettes de graphène à l'échelle nanométrique étant obtenues par un procédé mécanique ou chimique.

8. Matériau composite selon l'une des revendications précédentes, la couche composée de plaquettes de graphène à l'échelle nanométrique
a) présentant une conductivité thermique ≥ 1Wm⁻¹K⁻¹, et/ou
b) présentant une température de fusion ≥ 3725 °C, et/ou
c) présentant une résistance à la traction de 1 à 10 GPa, et/ou
d) une conductivité électrique ≤ 10⁷ n⁻¹ cm⁻¹.

9. Matériau composite selon l'une des revendications précédentes, le matériau composite étant obtenu par un procédé selon l'une des revendications 10 à 12.

10. Procédé de fabrication d'un matériau composite selon l'une des revendications 1 à 8, le procédé comprenant
a) la fourniture d'un alliage de magnésium tel que défini dans l'une des revendications 1 et 2,
b) la fourniture de plaquettes de graphène à l'échelle nanométrique telles que définies dans l'une des revendications 1, 6 et 7,
c) l'application des plaquettes de graphène à l'échelle nanométrique de l'étape b) sur au moins une partie de la surface de l'alliage de magnésium de l'étape a) en vue de fabriquer un matériau composite.

11. Procédé selon la revendication 10, l'application des plaquettes de graphène à l'échelle nanométrique sur au moins une partie de la surface de l'alliage de magnésium à l'étape c) étant effectuée par dépôt chimique en phase gazeuse (CVD), une croissance épitaxiale ou un dépôt depuis une matrice organique.

12. Procédé selon la revendication 10 ou 11, l'alliage de magnésium, avant l'étape c), étant prétraité par application d'un revêtement organique ou anorganique qui peut donner lieu à une conductivité de surface plus faible de l'alliage de magnésium.

13. Utilisation d'un matériau composite selon l'une des revendications 1 à 9 dans un véhicule de transport de passagers, notamment dans des aéronefs tels que des avions de ligne, des hélicoptères ou un aéronef sans pilote, dans un véhicule spatial, un véhicule de transport, notamment dans des trains et des navires, dans la construction automobile, la construction d'équipements, la construction de machines ou la construction d'outils.

14. Utilisation selon la revendication 13 dans une cellule d'aéronef.
